**Europäisches Patentamt**

**European Patent Office**

**Office européen des brevets**

(19)

(11) Veröffentlichungsnummer : **0 325 939 B1**

(12) # EUROPÄISCHE PATENTSCHRIFT

(45) Veröffentlichungstag der Patentschrift :
**12.04.95 Patentblatt 95/15**

(51) Int. Cl.[6] : **H01L 21/31, H01J 37/32**

(21) Anmeldenummer : **89100359.2**

(22) Anmeldetag : **11.01.89**

(54) **Verfahren zum Planarisieren von Halbleiteroberflächen.**

(30) Priorität : **23.01.88 DE 3801976**

(43) Veröffentlichungstag der Anmeldung :
**02.08.89 Patentblatt 89/31**

(45) Bekanntmachung des Hinweises auf die
Patenterteilung :
**12.04.95 Patentblatt 95/15**

(84) Benannte Vertragsstaaten :
**DE FR GB IT**

(56) Entgegenhaltungen :
**EP-A- 0 151 948**
**EP-A- 0 216 425**
**EP-A- 0 243 273**
**FR-A- 2 627 902**
**US-A- 4 666 553**
**Extended Abstracts, Band 86-2, 19.-24. Okto-**
**ber 1986, Seite 528, P.E. RILEY et al. :**
**"Planarization of dielectric layers for multile-**
**vel metallization"**

(56) Entgegenhaltungen :
**Extended Abstracts/Electrochemical Society,**
**Band 87-2, Oktober 1987, Seiten 685-6, A.**
**SCHILTZ et al. : "End-point detection of plas-**
**ma etched resist materials using optical emis-**
**sion of natural or additive tracers"**
**I.B.M. Technical Disclosure Bulletin, Bd 29, No**
**9, Feb. 1987, Seiten 4161-2; anonymer Bericht :**
**"Two-step quartz etchback process"**
**J. Vac. Sci. Technol., Bd. 16, No 2, Seiten**
**391-403, 1979.**

(73) Patentinhaber : **TEMIC TELEFUNKEN**
**microelectronic GmbH**
**Theresienstrasse 2**
**D-74072 Heilbronn (DE)**

(72) Erfinder : **Gellrich, Norbert, Dr.rer.nat.**
**Kirchhäuser Weg 49**
**D-7101 Massenbachhausen (DE)**

(74) Vertreter : **Maute, Hans-Jürgen, Dipl.-Ing.**
**TEMIC TELEFUNKEN microelectronic GmbH**
**Postfach 35 35**
**D-74025 Heilbronn (DE)**

**Beschreibung**

Die Erfindung betrifft ein Verfahren zum Planarisieren einer strukturierten Oberfläche einer Halbleiteranordnung, auf der eine einzuebnende Siliziumdioxidschicht ($SiO_2$) und anschließend eine die Oberfläche der Siliziumdioxid einebnende Polymerschicht mit einer ebenen Oberfläche aufgebracht ist, indem mittels eines durch Dissoziation eines gasförmigen Bestandteiles einer Gasatmosphäre erzeugten reaktiven, fluorhaltigen Gases die Oberfläche der Polymerschicht geätzt wird.

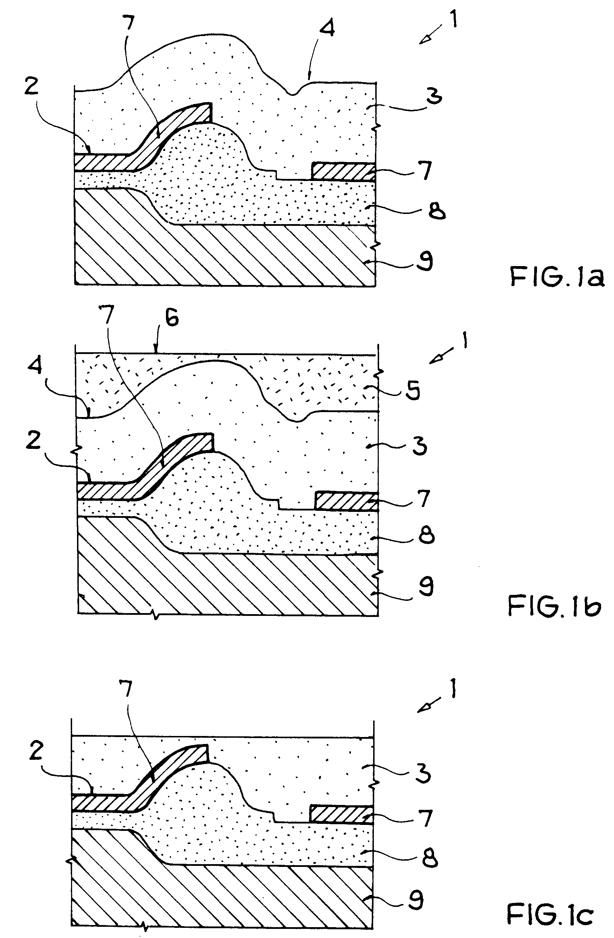

Die Bearbeitung von ursprünglich ebenen Halbleiteranordnungen zur Herstellung von integrierten Schaltungen führt zu einer Strukturierung der Halbleiteroberfläche, wie es in der Figur 1a, die eine Schnittdarstellung einer Halbleiteranordnung 1 zeigt, schematisch dargestellt ist. Dort ist auf einem Siliziumsubstrat 9 eine Siliziumoxidschicht 8 aufgetragen, auf der Leiterbahnen 7 aus Aluminium angeordnet sind, wodurch sich eine strukturierte Oberfläche 2 ergibt. Unterschiedliche Niveaus und Stufen auf der Oberfläche beeinträchtigen die nachfolgenden Prozesse, indem beispielsweise bei der Lithographie die Anforderung an die Fokustiefe höher wird und die Lackdickenvariation an Stufen zu Linienbreitenänderungen führt. Ein anderes Problem - als Steilkantenproblem bekannt - ergibt sich, wenn Metallschichten über Stufen geführt werden, weil dort das Metall abreißen kann und zu Unterbrechungen der Leiterbahnen führt. Um daher die Linienbreite der Strukturen auf der ganzen Oberfläche kontrollierbar zu machen sowie Leiterbahnunterbrechungen zu vermeiden, ist es notwendig, diese strukturierte Oberfläche der Halbleiteranordnung zu planarisieren. Hierzu wird eine Isolationsschicht 3, beispielsweise aus Siliziumdioxid, gemäß Figur 1a verwendet, die auf die strukturierte Oberfläche 2 aufgebracht wird und in einem weiteren Verfahrensschritt einzuebnen ist.

Zum Einebnen einer strukturierten Oberfläche einer Halbleiteranordnung sind aus dem Stand der Technik verschiedene Verfahren bekannt. Beispielsweise ist aus der Druckschrift "J. Electrochem. Soc.", Bd. 126, Sept. 1979, Seiten 1531 bis 1533 ein Verfahren bekannt, wonach die mit einer Isolierschicht versehenen Siliziumhalbleiterscheiben durch Aufschleudern eines Polymers, beispielsweise eines Photolackes, eingeebnet - wie Figur 1b, die die mit Polymer 5 eingeebnete Oberfläche 6 zeigt - und anschließend in einer argonhaltigen Atmosphäre einer Hochfrequenz-Zerstäubungsätzung (rf sputter etching) unterzogen wird. Hierbei wird gemäß der Figur 1c die durch das Polymer 5 eingeebnete Oberfläche 6 der Halbleiteranordnung 1 durch diesen Ätzvorgang in die einzuebnende Schicht 3, das Siliziumdioxid, übertragen. Der Grad der Einebnung hängt vom Polymer, den Aufschleuderbedingungen, der Topographie der Halbleiterscheibe und vor allem von der Temperaturbehandlung des aufgebrachten Polymers sowie von den Sputterbedingungen ab. Diese Sputterbedingungen bestimmen insbesondere das Ausmaß der Strahlenschäden, die die Halbleiteranordnung nachteilig beeinflussen können.

Weiterhin ist aus der EP 0 243 273 A2 ein Planarisierungsverfahren bekannt, wonach in einem zweistufigen Trockenätzverfahren eine strukturierte Oberfläche einer Halbleiteranordnung eingeebnet wird. Hierbei wird auf die strukturierte Oberfläche eine Isolationsschicht abgeschieden, und anschließend wird durch Aufschleudern eines Photolackes die Oberfläche dieser Isolationsschicht eingeebnet. Im ersten Verfahrensschritt dieses bekannten Verfahrens wird dieser Photolack mit einem sauerstoffhaltigen Prozeßgas, vorzugsweise reinen Sauerstoff, so lange geätzt, bis die Oberfläche der höchsten Erhebungen der Isolationsschicht freiliegen. Im zweiten Verfahrensschritt wird mit einem Prozeßgas, das im Vergleich zum ersten Verfahrensschritt einen reduzierten Sauerstoffgehalt aufweist, so lange geätzt, bis die Oberfläche der höchsten Erhebungen der unter der Isolationsschicht liegenden Metallschicht freiliegen. Das Prozeßgas enthält vorzugsweise $CF_4$, $C_2F_6$, $C_3F_8$, $CF_3Br$, $CHF_3$ oder $C_4F_8$. Der Sauerstoff im ersten Verfah rensschritt erhöht die Ätzrate des Photolackes, wogegen durch die richtige Wahl des Sauerstoffanteiles im zweiten Verfahrensschritt die Ätzrate des Photolackes an diejenige der Isolationsschicht angepaßt werden kann, wobei sich jedoch - wie weiter unten genauer ausgeführt wird - das Verhältnis von Photolackoberfläche zur Isolationsschichtoberfläche ständig ändern.

Steht kein auswertbares Endpunktsignal zum Abschalten des Ätzvorganges zur Verfügung, muß die Ätzdauer vorgegeben werden. Sie wird aus der vorher zu bestimmenden Ätzrate und der Dicke der zu ätzenden Schicht berechnet. Alle Schwankungen der Ätzparameter, der Dicke und der Qualität der Schicht von Halbleiterscheibe zu Halbleiterscheibe können nicht berücksichtigt werden, selbst wenn Schichtdicke und Ätzrate ständig kontrolliert werden und der Prozeß entsprechend angepaßt wird. Dieses Verfahren ist daher zeitaufwendig und kostenintensiv und für Produktionszwecke ungeeignet. Steht ein Endpunktsignal zur Verfügung, mit dessen Hilfe ein Prozeßschritt abgeschaltet werden kann, entfällt die aufwendige und teure Kontrolle von Ätzrate und Schichtdicke und jede Halbleiterscheibe wird optimal geätzt.

In den meisten Fällen sind Ätzanlagen, insbesondere Einzelscheibenanlagen, mit emissionsspektroskopischen Endpunktdetektoren ausgerüstet. Für die Ätzungen von Siliziumdioxid bietet sich die CO-Emissionslinie des Plasmas bei 519,8 nm an, beispielsweise ist dies aus der oben genannten EP-A-0 243 273 A2, Seite 4, Zeilen 31 bis 36, bekannt. Diese CO-Emissionslinie zeigt deutliche Intensitätsänderungen bei den Übergängen von Polymer zu Siliziumdioxid und von Siliziumdioxid zu Silizium und anderen Materialien, wie beispielsweise Aluminium. So wird in Extended Abstracts, Band 86-2, Seite 528 (1986) ein Planarisierungsverfahren, das demjenigen aus der EP-A-0243 273 entspricht, die CO-Emissionslinie zur automatischen Abschaltung des Prozesses eingesetzt.

Allerdings wird die Intensitätsänderung dieser Linie beim Übergang von Polymer auf Siliziumdioxid stark vermindert, wenn dem Ätzgas Sauerstoff zugegeben wird und verschwindet schon bei wenigen Volumenprozenten Sauerstoff im Ätzgas ganz. Deshalb kann diese CO-Emissionslinie nicht zur Endpunktdetektion eingesetzt werden, falls beispielsweise mit einem $CF_4O_2$-Gasgemisch die Ätzung durchgeführt wird.

Ein weiterer Nachteil ergibt sich aus den Ätzbedingungen der oben genannten Abtragungsverfahren, nach denen gleiche Ätzraten von Polymer und Siliziumdioxid durch ein geeignetes Verhältnis von $CF_4$ zu $O_2$ von Anfang an eingestellt werden. Eine ideale Übertragung der ebenen Polymeroberfläche ist jedoch nur dann sichergestellt, wenn während des Ätzvorganges dieses Verhältnis konstant bleibt, was bedeutet, daß das Flächenverhältnis von Polymer zu Siliziumdioxid sich nicht ändert. Denn bei der Ätzung von Siliziumdioxid wird zusätzlich Sauerstoff frei, der die Ätzgeschwindigkeit des Polymers erhöht. Ändert sich im Verlauf der Ätzung das Flächenverhältnis von Polymer zu Siliziumdioxid, wie es bei realen Bauelementen durch schräge Kanten und unterschiedliche Niveaus der Fall ist, so wächst die Polymerätzrate über die des Siliziumdioxids. Bei einem solchen Verfahren werden deshalb auch nur annähernd ebene Oberflächen erzielt.

Der Erfindung liegt somit die Aufgabe zugrunde, ein Planarisierungsverfahren mittels Ätzen der eingangs genannten Art anzugeben, das wirtschaftlich durchführbar und mit dem ferner eine hohe Güte der Ebenheit der Oberfläche erzielbar ist.

Diese Aufgabe wird erfindungsgemäß durch die kennzeichnenden Merkmale des Patentanspruches 1 gelöst.

Bei diesem erfindungsgemäßen Verfahren wird von Anfang an darauf verzichtet, exakt gleiche Ätzraten sowohl für das Polymer als auch für das Siliziumdioxid ($SiO_2$) einzustellen. Da der durch das Ätzen von Siliziumdioxid freigewordene Sauerstoff die Polymerätzrate, die anfangs etwas niedriger als die $SiO_2$-Ätzrate ist, mit zunehmend freigelegter $SiO_2$Schicht bei realen Halbleiterstrukturen ansteigen läßt, übertrifft nach einer gewissen Ätzdauer die Ätzrate des Polymers diejenige des Siliziumdioxids.

Es gibt daher nach einer bestimmten Ätzdauer einen ersten Zeitpunkt, an dem die Oberfläche eben, aber noch teilweise mit Polymer belegt ist. Dieser Zeitpunkt wird mit Hilfe der Intensitätsänderung der CO-Emissionslinie bestimmt, da während des Ätzprozesses die Intensität dieser Linie stark zunimmt. Hierbei wird der Pegel, bei dem der Prozeß unterbrochen wird, aus Erfahrungswerten gewonnen. Der hierdurch definierte erste Verfahrensschritt erfolgt in vorteilhafter Weise unabhängig von der Topographie der Oberfläche der Halbleiteranordnung immer etwa beim gleichen Flächenverhältnis von Siliziumdioxid zu Polymer. Daher kann der Prozeß im Hinblick darauf, daß die Intensität der CO-Emissionslinie bei konstanter $SiO_2$-Ätzrate im wesentlichen von der freigelegten Fläche der Siliziumdioxidschicht bestimmt wird, so eingestellt werden, daß zum Ende des ersten Verfahrensschrittes, wenn also eine ebene Oberfläche vorliegt, die freigelegte Fläche der Siliziumdioxidschicht groß gegenüber der verbleibenden Oberfläche der Polymerschicht ist. Die Pegeländerung der Intensität der CO-Emissionslinie dient somit in vorteilhafter Weise zum Abschalten des ersten Verfahrensschrittes.

In einem zweiten Verfahrensschritt braucht diese ebene Oberfläche nur noch so weit abgetragen zu werden, daß sie frei von Polymer ist. Hierzu muß der Ätzprozeß so eingestellt werden, daß für das Siliziumdioxid und das Polymer sich gleiche Ätzraten einstellen. Dies erfolgt dadurch, daß die Ätzrate des Polymers durch einen geeigneten Bestandteil, vorzugsweise Wasserstoff, den das im zweiten Verfahrensschritt zugeführte dissoziierte Gas enthält, so erniedrigt wird, daß die Ätzrate des Polymers trotz des nun hohen Anteils an Sauerstoff an diejenige des Siliziumdioxids angepaßt wird. Da nach Beendigung des ersten Prozeßschrittes der Flächenanteil des $SiO_2$ viel größer als der des Polymers ist, kann die weitere Zunahme des Sauerstoffs vernachlässigt werden. Die Dauer dieses Ätzschrittes hängt von der Stufentiefe der einzuebnenden Oberfläche ab und muß für jeden Bauelementtyp festgelegt werden. Die mit diesem Verfahrensschritt erzielte Oberfläche ist vollständig eben.

Das erfindungsgemäße Verfahren zeichnet sich durch große Wirtschaftlichkeit aus, die sich daraus ergibt, daß in der vorteilhaften Anwendung der Endpunktdetektion die ständige Kontrolle der Ätzrate und der Schichtdicke entfallen. Für jeden Ätzprozeß wird die für ihn richtige Ätzzeit automatisch eingestellt, so daß von Prozeßschwankungen unbeeinflußte, optimale Ergebnisse erzielt und unnötig lange Ätzzeiten vermieden werden, wodurch deutliche Durchsatzerhöhungen gegenüber anderen Verfahren erzielt werden.

In einer weiteren vorteilhaften Ausbildung des erfindungsgemäßen Verfahrens erfolgt die Dissoziation des gasförmigen Bestandteils der Gasatmosphäre mittels Plasma- oder Laseranregung, wodurch die Beobachtung der Emissionslinie des molekularen CO leicht beobachtet und aufgezeichnet werden kann. Beispielsweise wird ein einfacher optischer Detektor aus einem Interferenzfilter und einer PIN-Photodiode sowie einem Aufzeichnungsgerät aufgebaut.

Gemäß einer weiteren vorteilhaften Ausbildung der Erfindung kann zur Ätzung der Polymer- und der Siliziumdioxidschicht ein gewisser Anteil an Sauerstoff der Halbleiteranordnung zugeführt werden. Bei diesem erfindungsgemäßen Verfahren bleibt der Anteil an Sauerstoff so gering, daß immer noch eine Intensitätsänderung der CO-Emissionslinie beim Übergang der Ätzung von der Polymerschicht zur Siliziumdioxidschicht erfolgt, um auch dann noch diese CO-Emissionslinie als Endpunktsignal der Ätzung heranziehen zu können. Durch diesen geringen Anteil an Sauerstoff kann der Durchsatz in der Produktion nochmals um einen Faktor von ca. 1,2 erhöht werden. Als besonders vorteilhaft erweist sich ein Anteil an Sauerstoff von ca. 2 Volumenprozent. Hierdurch muß allerdings eine geringfügige Verschlechterung der Oberflächenebenheit in Kauf genommen werden.

Gemäß einer bevorzugten Weiterbildung der Erfindung wird im ersten Verfahrensschritt $CF_4$ als Ätzgas verwendet und anschließend im zweiten Verfahrensschritt $CHF_3$-Gas zugeführt.

Im folgenden wird die Erfindung anhand spezieller Ausführungsformen des erfindungsgemäßen Verfahrens näher erläutert. In den zugehörigen Zeichnungen zeigen:

Figur 2a in schematischer Darstellung den Querschnitt einer Halbleiteranordnung mit strukturierter Oberfläche,

Figur 2b in schematischer Darstellung den Querschnitt einer zu planarisierenden Halbleiteranordnung nach Figur 2a, und

Figur 3 die Endpunktkurve beim Planarisieren.

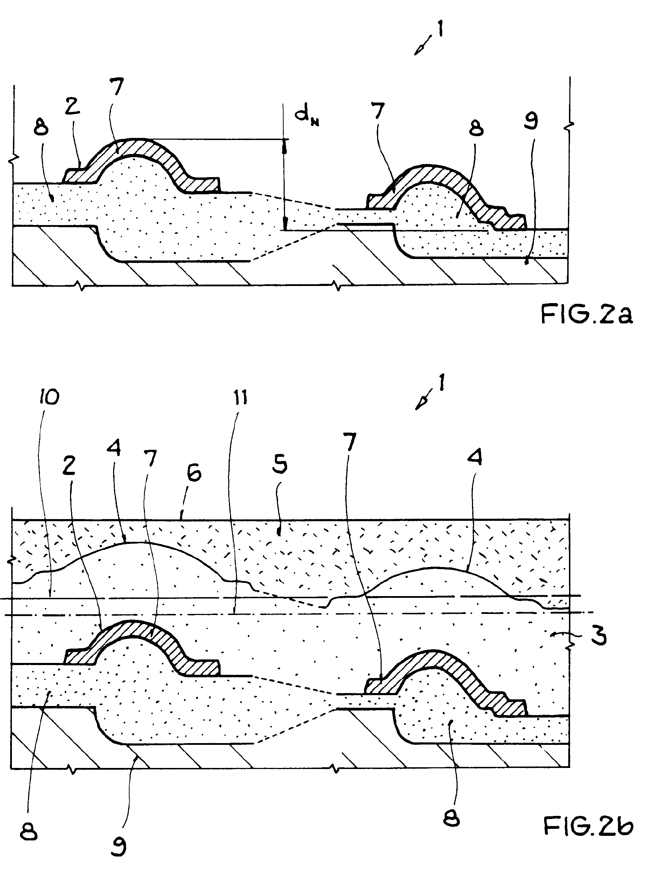

Nach Figur 2a ist die Halbleiteranordnung 1 so aufgebaut, daß auf einem Siliziumsubstratkörper 9 eine Oxidschicht 8 angeordnet ist und darauf die Leitbahnen 7 aus Aluminium verlaufen, wodurch sich eine strukturierte Oberfläche 2 ergibt. Diese Oberfläche 2 wird gemäß Figur 2b mit einer zu planarisierenden Siliziumdioxid schicht 3, versehen, deren Dicke D sich aus dem höchsten Niveauunterschied $d_N$ (siehe Figur 2a), den die erste Aluminiumschicht 7 einschließlich deren Dicke erzeugt und der Dicke, die zur Isolation wenigstens notwendig ist, zum Beispiel 0,5 μm, ergibt, d.h.

$$D = d_N + 0,5 \text{ μm}.$$

So ergibt sich beispielsweise für einen Niveauunterschied $d_N$ von 2,5 μm eine Oxiddicke von 3,0 μm. Die Oberfläche 4 dieser Oxidschicht weist ebenfalls die Struktur der darunterliegenden Oberfläche 2 auf und wird nach dem Messen der Oxiddicke mit Hilfe eines Polymers 5 eingeebnet, wie es die Figur 2b zeigt, so daß sich eine ebene Oberfläche 6 ergibt. Anschließend wird die Polymerschicht bei einer Temperatur von 180 °C zwei bis vier Minuten lang auf einer "hot plate" ausgeheizt.

Als nächster Prozeßschritt folgt das eigentliche Planarisieren mittels des erfindungsgemäßen Verfahrens. Hierbei wird die Polymerschicht und die Oxidschicht mittels Plasmaätzen in einem Parallelplattenreaktor abgeätzt, wonach die zu planarisierende Halbleiteranordnung 1 auf einer der beiden in der Plasmakammer sich befindenden Elektroden angeordnet ist, wobei diese Elektroden einen Abstand von 3,8 mm aufweisen.

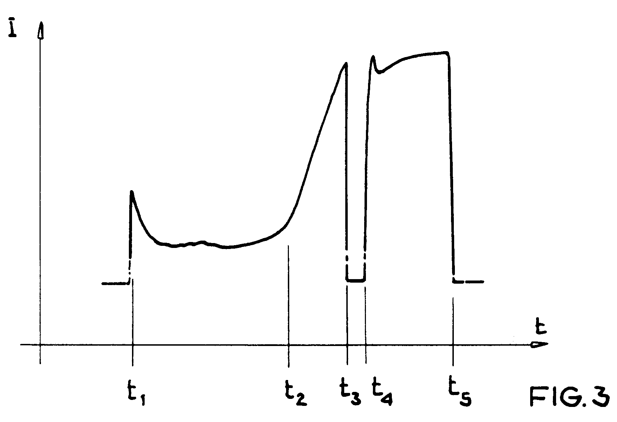

Der Prozeß beginnt mit einer Stabilisierungsphase, in der mit einem Druck von 2,8 Torr Helium (1 Torr = 133.3 Pa) und $CF_4$-Gas mit 170 sccm bzw. 120 sccm durch die Kammer des Reaktors geleitet wird. Anschließend beginnt der erste Verfahrensschritt zum Zeitpunkt $t_1$ mit der Zuführung der rf-Leistung von 900 Watt, wobei gleichzeitig die Endpunktkurve gemäß Figur 3 aufgenommen wird, nach der ab einer gewissen Ätzdauer, ungefähr zum Zeitpunkt $t_2$, die Intensität der CO-Emissionslinie stark zunimmt, da zu diesem Zeitpunkt der Ätzvorgang die Oxidschicht 3 erreicht hat. Nach einer weiteren Ätzdauer wird zum Zeitpunkt $t_3$, nach einer gesamten Ätzdauer von etwa 2 Minuten und bei einer Stufenhöhe von etwa 2,5 μm, das Ende des ersten Verfahrenschrittes erreicht, bei dem eine ebene Oberfläche 10 ausgebildet ist, die aber noch Reste des Polymers 5 aufweist, die durch die durchgezogene Linie 10 in Figur 2b dargestellt ist. Der durch die Intensitätsänderung der CO-Emissionslinie definierte Pegel, der zur Abschaltung des Prozesses führt, wird aufgrund von Versuchen festgelegt und ergibt sich unabhängig von der Struktur der zu planarisierenden Oberfläche der Halbleiteroberanordnung. Nun wird die Energiezuführung unterbrochen und dem Prozeßgas $CHF_3$-Gas mit 20 sccm und einem Druck von 2,8 Torr zugeführt. Nach einer weiteren Stabilisierungsphase beginnt der zweite Verfahrensschritt zum Zeitpunkt $t_4$ (vergleiche Figur 3) mit einer rf-Leistung von 900 Watt, wobei während einer Ätzdauer von 75 Sekunden die ebene Oberfläche 10 vollständig in die Oxidschicht 3 übertragen wird, so daß sich eine ebene Oberfläche 11 gemäß der punktgestrichelten Linie in Figur 2b ergibt. Der Zeitpunkt $t_5$ gemäß Figur 3 markiert den Endpunkt des zweiten Verfahrensschrittes, der unter anderem auch von der erforderlichen Dicke der verbleibenden Isolierschicht abhängt.

Ab diesem Zeitpunkt nimmt die Intensität der CO-Emissionslinie nicht mehr zu, sondern bleibt konstant, da die zu ätzende Oberfläche nur aus Siliziumdioxid besteht. Die Intensität nimmt erst dann ab, wenn die Ätzung so weit fortgeschritten ist, daß in einigen Bereichen der Oberfläche die Aluminiumschicht freiliegt. Diese Abnahme der Intensität kann dann als Endpunktsignal für das Ende des zweiten Verfahrensschrittes benützt werden. Dann muß aber, da die Aluminiumschicht an wenigen Stellen freiliegt, eine zweite Oxidschicht als Passivierung auf die ebene Oberfläche aufgebracht werden.

Bei der Verwendung von Plasmaoxid als Isolationsschicht empfiehlt sich in jedem Fall eine Nachbeschichtung mit $SiO_2$, um das Auftreten von pinholes durch den gesamten Isolator weitgehend zu verhindern.

Die Ätzdauer des ersten Verfahrensschrittes ist unabhängig von der Struktur der Oberfläche, wohingegen die Ätzzeit des zweiten Verfahrensschrittes von der Stufenhöhe der Schaltung abhängt, wodurch für jede neue Schaltung diese Ätzzeit ermittelt werden muß. Dies kann dann entfallen, wenn wie oben beschrieben, die CO-Emissionslinie als Endpunktsignal auch für den zweiten Verfahrensschritt herangezogen wird.

Durch dieses erfindungsgemäße Verfahren wird ein produktionsgerechter Prozeß durchführbar, der einen hohen Durchsatz und somit auch eine hohe Wirtschaftlichkeit garantiert.

**Patentansprüche**

1. Verfahren zum Planarisieren einer strukturierten Oberfläche (2) einer Halbleiteranordnung (1), auf der eine einzuebnende Siliziumdioxidschicht ($SiO_2$) (3) und anschließend eine die Oberfläche (4) der Siliziumdioxidschicht (3) einebnende Polymerschicht (5) mit einer ebenen Oberfläche (6) aufgebracht ist, indem mittels eines durch Dissoziation eines gasförmigen Bestandteiles einer Gasatmosphäre erzeugten reaktiven, fluorhaltigen Gases die Oberfläche (6) der Polymerschicht (5) geätzt wird, dadurch gekennzeichnet, daß

a) in einem ersten Verfahrensschritt

a1) das reaktive, fluorhaltige Gas im wesentlichen frei von Sauerstoff ist und dieses Gas der Oberfläche (6) der Polymerschicht (5) zugeführt wird und mit derselben solange reagiert, bis die Siliziumdioxidschicht (3) zu einem ersten Zeitpunkt ($t_2$) erreicht wird, wobei die Ätzrate des Polymers (5) zu diesem ersten Zeitpunkt ($t_2$) geringer ist als diejenige der Siliziuimdioxidschicht (3) und

a2) im weiteren Verlauf das reaktive, fluorhaltige Gas sowohl mit den Polymer (5) als auch mit der Siliziumdioxidschicht (3) reagiert, wobei die Ätzrate des Polymers (5) aufgrund des durch die Reaktion mit der Siliziumdioxidschicht (3) freiwerdenden Sauerstoffs die Ätzrate der Siliziumdioxidschicht (3) übertrifft, daß zu einem zweiten Zeitpunkt ($t_3$) eine ebene Oberfläche (10) erzielt wird, die noch Reste der Polymerschicht (5) aufweist, und

a3) zur Endpunktbestimmung des zweiten Zeitpunktes ($t_3$) die Intensitätsänderung

der CO-Emissionslinie beim Übergang der Ätzung von der Polymerschicht (5) zur Isolationsschicht 3 eingesetzt wird, wobei der dem zweiten Zeitpunkt ($t_3$) entsprechende Pegel des Wertes der Intensität der CO-Emissionslinie aufgrund des Flächenverhältnisses der verbleibenden Oberfläche des Polymers zu der Oberfläche des freigelegten Silziumdioxids in diesem zweiten Zeitpunkt ($t_3$) durch Versuchefestgelegt wird, und

b) in einem zweiten Verfahrensschritt

b1) dem reaktiven, fluorhalten Gas zusätzlich ein geeigneter Bestandteil zur Erniedrigung der Ätzrate des Polymers zugeführt wird, so daß die Ätzrate des Polymers (5) an diejenige der Siliziumdioxidschicht (3) angepaßt wird und

b2) dieses reaktive, fluorhaltige Gas mit dem genannten Bestandteil so lange mit der zum zweiten Zeitpunkt ($t_3$) hergestellten ebenen Oberfläche (10) reagiert, bis sie vollständig in die einzuebnende Siliziumdioxidschicht (3) übertragen ist.

2. Verfahren nach Anspruch 1, dadurch gekennzeichnet, daß das reaktive, fluorhaltige Gas $CF_4$-Gas ist.

3. Verfahren nach Anspruch 1 oder 2, dadurch gekennzeichnet, daß im zweiten Verfahrensschritt der zusätzliche Bestandteil aus wasserstoffhaltigem Gas besteht.

4. Verfahren nach Anspruch 3, dadurch gekennzeichnet, daß das wasserstoffhaltige Gas $CHF_3$-Gas ist.

5. Verfahren nach einem der vorangehenden Ansprüche, dadurch gekennzeichnet, daß die Dissoziation durch Plasma- oder Laseranregung erfolgt.

6. Verfahren nach einem der vorangehenden Ansprüche, dadurch gekennzeichnet, daß ein zusätzlicher Anteil Sauerstoff an dem der Oberfläche der Polymerschicht (5) zugeführten reaktiven Gases so gewählt wird, daß die CO-Emissionslinie beim Übergang der Ätzung von der Polymerschicht (5) zur Isolationsschicht (3) eine noch auswertbare Intensitätsänderung aufweist.

7. Verfahren nach Anspruch 6, dadurch gekennzeichnet, daß der Anteil des Sauerstoffs 2 Volumenprozent beträgt.

**Claims**

1. A process for the planarization of a structured surface (2) of a semiconductor arrangement (1) on which are arranged a silicon dioxide layer (SiO$_2$) (3) to be levelled and then a polymer layer (5) which has a flat surface (6) and which levels the surface (4) of the silicon dioxide layer (3), in that the surface (6) of the polymer layer (5) is etched by means of a reactive, fluorine-containing gas generated by dissociation of a gaseous constituent of a gas atmosphere, characterised in that

   a) in a first process step

   a1) the reactive, fluorine-containing gas is substantially free of oxygen and this gas is supplied to the surface (6) of the polymer layer (5) and reacts with the latter until the silicon dioxide layer (3) is reached at a first time (t$_2$), where the etching rate of the polymer (5) at this first time (t$_2$) is lower than that of the silicon dioxide layer (3) and

   a2) as a further part of the process the reactive, fluorine-containing gas reacts both with the polymer (5) and with the silicon dioxide layer (3), where, due to the oxygen released by the reaction with the silicon dioxide layer (3), the etching rate of the polymer (5) exceeds the etching rate of the silicon dioxide layer (3), that at a second time (t$_3$) a flat surface (10) is obtained which still exhibits residues of the polymer layer (5), and

   a3) the change in intensity in the CO emission line at the transition of the etching from the polymer layer (5) to the insulation layer (3) is used to determine the end point of the second time (t$_3$), where the level of the value of the intensity of the CO emission line corresponding to the second time (t$_3$) is determined by experiment on the basis of the surface ratio of the remaining surface of the polymer to the surface of the exposed silicon dioxide at this second time (t$_3$),

   b) in a second process step

   b1) the reactive, fluorine-containing gas is additionally supplied with a suitable constituent to reduce the etching rate of the polymer so that the etching rate of the polymer (5) is matched to that of the silicon dioxide layer (3) and

   b2) this reactive, fluorine-containing gas with the aforementioned constituent reacts with the flat surface (10) produced at the second time (t$_3$) until it has been completely transferred into the silicon dioxide layer (3) to be levelled.

2. A process as claimed in Claim 1, characterised in that the reactive, fluorine-containing gas is CF$_4$.

3. A process as claimed in Claim 1 or 2, characterised in that in the second process step the additional constituent consists of hydrogenous gas.

4. A process as claimed in Claim 3, characterised in that the hydrogenous gas is CHF$_3$.

5. A process as claimed in one of the preceding claims, characterised in that the dissociation takes place as a result of plasma- or laser excitation.

6. A process as claimed in one of the preceding claims, characterised in that a proportion of oxygen added to the reactive gas supplied to the surface of the polymer layer (5) is selected such that at the transition of the etching from the polymer layer (5) to the insulation layer (3) the CO emission line exhibits a still analysable change in intensity.

7. A process as claimed in Claim 6, characterised in that the proportion of the oxygen amounts to 2 vol. %.

**Revendications**

1. Procédé pour aplanir une surface (2) structurée d'un dispositif semi-conducteur (1), sur laquelle sont appliquées une couche (3) de dioxyde de silicium (SiO$_2$) à niveler et ensuite une couche (5) de polymère qui nivelle la surface (4) de la couche (3) de dioxyde de silicium et possède une surface (6) plane, procédé selon lequel on attaque la surface (6) de la couche (5) de polymère au moyen d'un gaz réactif fluoré produit par dissociation d'un composant gazeux d'une atmosphère gazeuse, caractérisé en ce que

   a) dans une première étape du procédé

   a1) le gaz réactif fluoré est essentiellement exempt d'oxygène et on amène ce gaz à la surface (6) de la couche (5) de polymère pour le faire réagir avec celle-ci jusqu'à ce que, à un premier instant (t$_2$), la couche (3) de dioxyde de silicium soit atteinte, le taux d'attaque du polymère (5) à ce premier instant (t$_2$) étant plus faible que celui de la couche (3) de dioxyde de silicium et

   a2) par la suite, on fait réagir le gaz réactif fluoré à la fois avec le polymère (5) et avec la couche (3) de dioxyde de silicium, pendant que le taux d'attaque du polymère (5) dépasse le taux d'attaque de la couche (3) de dioxyde de silicium en raison de l'oxygène libéré par la réaction avec la couche (3) de dioxyde de silicium, de manière que, à un second instant ($t_3$), on obtienne une surface (10) plane qui présente encore des restes de la couche (5) de polymère, et

a3) pour déterminer le point final correspondant au second instant ($t_3$), on utilise le changement d'intensité de la raie d'émission de CO au passage de l'attaque de la couche (5) de polymère à celle de la couche isolante (3), le niveau de la valeur de d'intensité de la raie d'émission de CO correspondant au second instant ($t_3$) étant fixé par des essais, sur la base du rapport de la surface restante du polymère à la surface du dioxyde de silicium dénudé à ce second instant ($t_3$), et

b) dans une seconde étape du procédé

b1) on ajoute en plus au gaz réactif fluoré un composant approprié pour abaisser le taux d'attaque du polymère, de manière que le taux d'attaque du polymère (5) soit adapté à celui de la couche (3) de de dioxyde de silicium, et

b2) on fait réagir ce gaz réactif fluoré, contenant le composant mentionné, avec la surface (10) plane obtenue au second instant ($t_3$), jusqu'à ce que cette surface plane ait été transposée complètement dans la couche (3) de dioxyde de silicium à niveler.

2. Procédé selon la revendication 1, caractérisé en ce que le gaz réactif fluoré est du $CF_4$.

3. Procédé selon la revendication 1 ou 2, caractérisé en ce que, dans la seconde étape du procédé, le composant supplémentaire est un gaz contenant de l'hydrogène.

4. Procédé selon la revendication 3, caractérisé en ce que le gaz contenant de l'hydrogène est du $CHF_3$.

5. Procédé selon une des revendications précédentes, caractérisé en ce que la dissociation est produite par excitation plasmatique ou laser.

6. Procédé selon une des revendications précédentes, caractérisé en ce que l'on choisit une proportion supplémentaire d'oxygène, ajoutée au gaz réactif amené à la surface de la couche (5) de polymère, de manière que la raie d'émission de CO présente un changement d'intensité encore exploitable au passage de l'attaque de la couche (5) de polymère à celle de la couche isolante (3).

7. Procédé selon la revendication 6, caractérisé en ce que la proportion d'oxygène correspond à 2 pourcent en volume.

FIG.1a

FIG.1b

FIG.1c

FIG.2a

FIG.2b

FIG. 3